# FASCICULE DE BREVET EUROPEEN

(11) **EP 2 180 512 B1**
(45) Date de publication et mention de la délivrance du brevet: **12.12.2018**
(21) Numéro de dépôt: 09173970.6
(22) Date de dépôt: 23.10.2009
(51) Int. Cl.: H01L 27/146, H01L 31/0232, H01L 31/0352, H01L 31/101, B82Y 20/00

(54) **Dispositif d'imagerie polarimetrique optimise par rapport au contraste de polarisation**
Vorrichtung zur polarimetrischen Bildgebung, die im Hinblick auf den Polarisationskontrast optimiert ist
Polarimetric imaging device optimised in relation to polarisation contrast

(30) Priorité: 24.10.2008 FR 0805916
(43) Date de publication de la demande: 28.04.2010
(73) Titulaire: SOFRADIR, 92290 Châtenay Malabry (FR)
(72) Inventeur: Nedelcu, Alexandru, 92340 Bourg La Reine (FR); Bois, Philippe, 77240 Cesson (FR); Costard, Eric, 91300 Massy (FR)
(74) Mandataire: Cabinet Laurent & Charras

(56) Documents cités:
- EP-A- 1 174 927
- NEDELCU A ET AL: "Small pitch, large format long-wave infrared QWIP focal plane arrays for Polarimetrie imagery", PROCEEDINGS OF SPIE - THE INTERNATIONAL SOCIETY FOR OPTICAL ENGINEERING - INFRARED TECHNOLOGY AND APPLICATIONS XXXIII 2007 SPIE US, vol. 6542, no. I, 2007, XP002532743,

## Description

Le domaine de l'invention est celui des détecteurs d'ondes électromagnétiques en matériau semiconducteur et notamment à structure à multi-puits quantiques, particulièrement adaptés au domaine infrarouge.

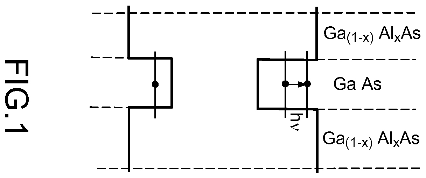

Les progrès rapides de la croissance par épitaxie sur substrat de type GaAs ont permis le développement d'une nouvelle classe de détecteurs d'ondes électromagnétiques utilisant l'absorption d'un rayonnement autour d'une longueur d'onde lambda, correspondant à la transition d'électrons entre différents niveaux d'énergie au sein d'une même bande d'énergie. Le schéma de la figure 1 illustre ce type de transition.

L'évolution récente des performances de ce type de composants est liée en particulier à la réalisation relativement facile de structures multicouches de semiconducteurs dans le système standard de l'épitaxie par jets moléculaires (MBE), c'est-à-dire le système GaAs/Ga₍₁₋ₓ₎AlₓAs. En ajustant les paramètres de croissance, l'épaisseur des puits quantiques et le pourcentage x en Aluminium dans les barrières imposant le potentiel de confinement, on peut choisir de centrer une bande étroite de détection (environ 1 micron) sur une longueur d'onde donnée. Un "micron" est un micromètre.

Ce type de structure présente l'intérêt de fournir de très bonnes sensibilités en raison de la discrétisation des niveaux d'énergie au sein des bandes de conduction des matériaux photoconducteurs utilisés.

Ainsi les détecteurs à multi-puits quantiques se sont imposés comme une très bonne solution technique pour la réalisation de matrices sensibles au rayonnement infrarouge dans la bande 8-12 µm.

Dans le contexte des transitions intersousbande, pour que ce type de transition soit possible il est nécessaire que le champ électrique de l'onde électromagnétique incidente ait une composante le long de la direction de croissance des couches (direction perpendiculaire au plan des couches). La conséquence de cet effet physique est qu'un détecteur présente peu d'absorption dans le cas d'une illumination à incidence normale.

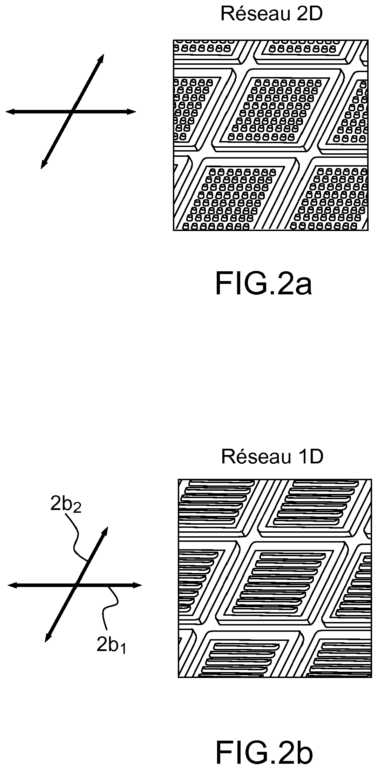

Il a déjà été proposé d'utiliser des moyens de couplage de type réseau de diffraction (cf Goossen et Lyon, APL 47(1985), p1257-1259) pour générer ladite composante perpendiculaire en créant des rayonnements diffractés. On peut ainsi graver sur chaque pixel un réseau de diffraction fonctionnant en réflexion (les détecteurs sont éclairés en face arrière) comme décrit dans l'article "Grating-coupled quantum-well infrared detectors: Theory and performance", J. Y. Anderson and L. Lundqvist, J. Appl. Phys. 71, 3600 (1992) et illustré en figure 2a qui met en évidence l'utilisation de réseaux de plots permettant de coupler le rayonnement incident quelle que soit sa polarisation.

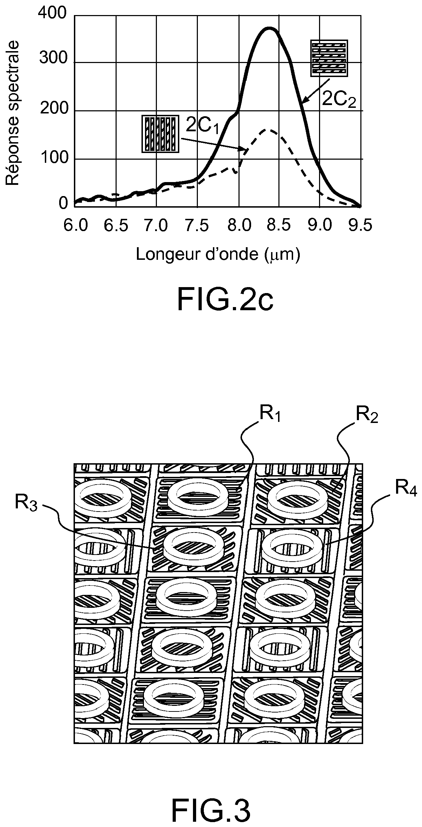

En remplaçant le réseau matriciel de plots à deux dimensions illustré en figure 2a, couramment dénommé réseau « 2D » par un réseau lamellaire à une dimension illustré en figure 2b, couramment dénommé réseau « 1D », on favorise le couplage de la polarisation incidente perpendiculaire au motif comme le montrent les résultats de la figure 2c qui montrent une courbe 2c₁ et une courbe 2c₂ respectivement relatives à l'utilisation d'un réseau 1D orienté comme représenté selon la flèche 2b₁ par rapport à une première direction de polarisation et à l'utilisation d'un réseau 1D orienté comme représenté selon la flèche 2b₂ par rapport à une seconde direction de polarisation orthogonale à la première direction. On obtient ainsi un pixel sensible à la polarisation incidente.

L'imagerie polarimétrique présente le grand intérêt de permettre de déceler plus facilement des objets manufacturés pouvant notamment être de type métallique dans une scène observée et ainsi d'exploiter de nouvelles sources de contraste, dans des conditions de faible contraste thermique.

Le principe de ce type de détecteur a été démontré sur des pixels compatibles avec la fabrication de matrices grand format (avec un pas de motif inférieur à 25µm) : "High contrast polarization sensitive quantum well infrared photodetectors", T. Antoni, A. Nedelcu, X. Marcadet, H. Facoetti, V. Berger, Appl. Phys. Lett. 90, 201107 (2007).

Il a aussi été montré que le paramètre pertinent pour ce type de système est le contraste de signal total (I₁-I₂)/(I₁+I₂), où I₁ et I₂ sont des courants délivrés par deux pixels dont les motifs dits « 1D » sont orthogonaux.

On constate que la réponse d'un pixel polarimétrique n'est pas parfaitement polarisée : elle est non nulle pour une polarisation parallèle au motif 1D de type lamellaire. Ceci est du à une contribution au couplage optique induite par les bords du pixel équivalente à des effets de taille finie. Cette contribution n'est pas sensible à la polarisation.

Un imageur thermique sensible à la polarisation a ainsi été développé par la société Thales Optronics Ltd., dont le plan focal est une matrice à multi-puits quantiques couramment désignés par l'acronyme « QWIP », au pas de 20 µm fabriquée par ATL III-V Lab comme décrit dans l'article "Small pitch, large format long-wave infrared QWIP focal plane arrays for polarimetric imagery", A. Nedelcu, H. Facoetti, E. Costard, P. Bois, SPIE 6542, 65420U (2007).

Cet imageur présente une structure monolithique intégrant une matrice de détecteurs et une matrice de polariseurs au niveau du plan focal. Il est à noter que dans le domaine infrarouge, la technologie dite « QWIP » est la seule à permettre cette intégration.

Ce plan focal est construit à partir d'une cellule élémentaire de 2x2 pixels, chaque pixel ayant un motif lamellaire orienté différemment comme l'illustre la figure 3 qui met en évidence quatre type de réseaux de diffraction 1D différents, R1, R2, R3 et R4. En combinant les signaux des quatre pixels, il est possible d'imager le degré de polarisation linéaire dans la scène. Pour conserver la résolution de l'image on utilise un système de micro-balayage. Quatre trames vidéo sont nécessaires pour construire quatre images contenant des informations polarimétriques différentes. La couche active est optimisée pour permettre un fonctionnement à haute cadence trame (200 Hz, temps d'intégration de 5 millisecondes), ce qui autorise une cadence proche de 50 Hz après traitement.

L'architecture décrite ci-dessus pose néanmoins un problème. En effet, comme la réponse de chaque pixel n'est pas parfaitement polarisée, ce phénomène étant mis en évidence grâce à la figure 2c, cela génère une réduction du contraste par rapport à un système idéal.

C'est pourquoi, la présente invention propose une nouvelle architecture de dispositif d'imagerie polarimétrique présentant un plan focal matriciel comportant une couche sensible à base de multi-puits quantiques et des moyens de couplage optique permettant de faire de l'imagerie polarimétrique sans altérer de manière significative le contraste.

Plus précisément la présente invention a pour objet un dispositif d'imagerie polarimétrique selon la revendication 1.

Il est à noter que la réponse du pixel sans réseau est uniquement due au couplage optique par les bords du pixel. Elle n'est pas sensible à la polarisation.

Selon une variante de l'invention, le quatrième pixel ne comporte pas de réseau diffractif.

Selon une variante de l'invention, le quatrième pixel comporte un quatrième réseau diffractif non sélectif en polarisation.

Selon l'invention, le dispositif comporte en outre des moyens de traitement des signaux récupérés au niveau des pixels de détection.

Selon l'invention, les moyens de traitement des signaux comprennent des moyens de sommation des signaux issus respectivement des premier, second, troisième pixels de détection et des moyens de soustraction du signal issu du quatrième pixel de détection.

On est ainsi en mesure de s'affranchir de la contribution non polarisée de chaque pixel. Cette dernière contient le signal optique non polarisé (dû au couplage par les bords) mais aussi le courant d'obscurité

Elle peut être mesurée à l'aide du pixel non sélectif en polarisation et être soustraite du signal des trois autres pixels.

Selon une variante de l'invention, le troisième pixel comporte un réseau diffractif sensible à une troisième polarisation orientée selon un angle de l'ordre de 45°.

Selon une variante de l'invention, les premier, second et troisième réseaux de diffraction sont des réseaux à une dimension comportant des motifs lamellaires.

Selon une variante de l'invention, le dispositif d'imagerie polarimétrique comprend un empilement de couches réalisé à la surface d'un substrat, ledit empilement comprenant la structure à multi-puits quantiques et des couches externes, les motifs lamellaires étant gravés au sein d'une couche externe.

Selon une variante de l'invention, l'empilement des couches est un empilement de couches de type GaAs ou InGaAs dopé (constituant les puits) et AlGaAs ou InAlAs non dopé (constituant les barrières), le substrat étant de type GaAs ou InP non dopé.

Selon une variante de l'invention, la structure à multi-puits quantiques est composée d'une alternance de couches de GaAs dopé et de couches de GaAlAs non dopé, les couches externes étant des couches de contact ohmique à base de GaAs plus fortement dopées que celles constitutives de la structure à multipuits quantiques.

Selon une variante de l'invention, le dispositif de l'invention comprend un substrat transparent à la longueur d'onde du rayonnement incident et une couche réflectrice à ladite longueur d'onde, ladite couche réflectrice étant à la surface des réseaux de diffraction, de manière à faire fonctionner le détecteur en réflexion.

Ainsi selon l'invention, le dispositif de l'invention permet de faire de l'imagerie polarimétrique dans l'ensemble du spectre infrarouge 3-20 µm.

En autorisant la soustraction des effets de bord la présente invention permet d'augmenter le contraste polarimétrique.

L'invention sera mieux comprise et d'autres avantages apparaîtront à la lecture de la description qui va suivre donnée à titre non limitatif et grâce aux figures annexées parmi lesquelles :
- la figure 1 illustre une structure à multipuits quantiques selon l'art connu ;
- les figures 2a, 2b, 2c illustrent respectivement une structure d'imageur comportant un réseau 2D, une structure d'imageur comportant un réseau 1D et l'évolution de la réponse spectrale de ces deux structures;

- la figure 3 illustre un dispositif d'imagerie polarimétrique comportant un plan focal à multi-puits quantiques QWIP selon l'art antérieur;
- la figure 4 illustre un premier exemple de dispositif d'imagerie comportant un plan focal optimisé par rapport au contraste polarimétrique selon l'invention;
- la figure 5 illustre un second exemple de dispositif d'imagerie comportant un plan focal optimisé par rapport au contraste polarimétrique selon l'invention;
- la figure 6 illustre un exemple de réalisation de plan focal utilisé dans un imageur de l'invention.

### Premier exemple d'imageur selon l'invention :

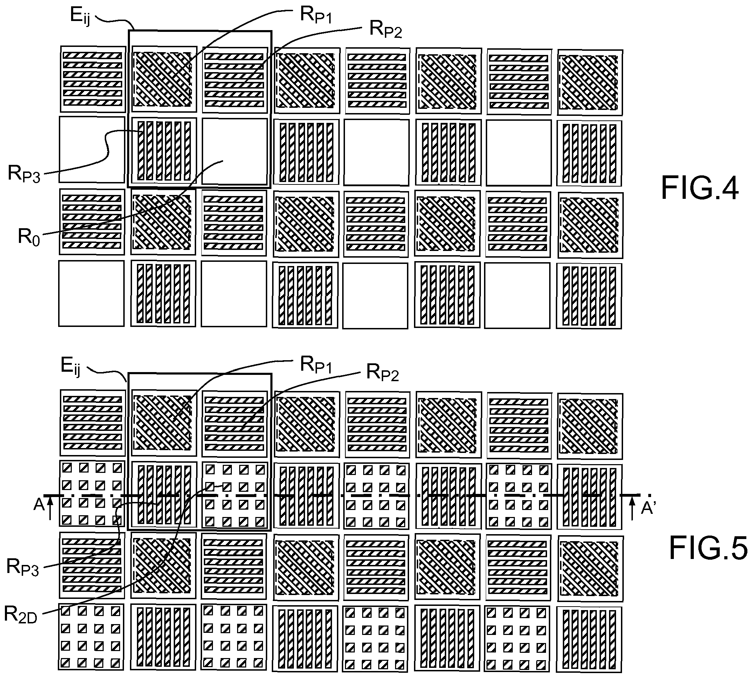

La figure 4 illustre une première variante de l'invention dans laquelle l'imageur comporte une structure à multi-puits quantiques MPQ comprenant un ensemble d'éléments de détection à la surface desquels sont réalisés des réseaux de diffraction sensibles sélectivement en terme de polarisation. Plus précisément, cet ensemble comporte des sous-ensembles Eij constitués de quatre sous-pixels comportant respectivement chacun un premier réseau de diffraction 1D sensible à une première polarisation R_{P1}, un deuxième réseau de diffraction 1D sensible à une deuxième polarisation R_{P2}, un troisième réseau de diffraction 1D sensible à une troisième polarisation R_{P3} et un quatrième sous-pixel sans réseau de diffraction et référencé sur la figure R₀. Typiquement la seconde polarisation est orthogonale à la première, la troisième polarisation faisant un angle d'environ 45 degrés avec la première. L'imageur comporte en outre des moyens de traitement du signal permettant de restituer une information en terme d'imagerie polarimétrique de qualité.

### Deuxième exemple d'imageur selon l'invention :

La figure 5 illustre une seconde variante de l'invention dans laquelle l'imageur comporte une structure à multi-puits quantiques MPQ comprenant un ensemble d'éléments de détection à la surface desquels sont réalisés des réseaux de diffraction sensibles sélectivement en terme de polarisation. Plus précisément, cet ensemble comporte des sous-ensembles constitués de quatre sous-pixels comportant respectivement chacun un premier réseau de diffraction 1D sensible à une première polarisation R_{P1}, un deuxième réseau de diffraction 1D sensible à une deuxième polarisation R_{P2}, un troisième réseau de diffraction 1D sensible à une troisième polarisation R_{P3} et un quatrième sous-pixel avec un réseau de diffraction par exemple 2D R_{2D} non sélectif en longueur d'onde. L'imageur comporte également des moyens de traitement du signal permettant de restituer une information en terme d'imagerie polarimétrique de qualité.

De manière connue, le dispositif d'imagerie polarimétrique de l'invention peut être réalisé à la surface d'un substrat en matériau semiconducteur S. A la surface de ce matériau semiconducteur, on procède à un assemblage de couches constituant un contact ohmique dit inférieur Ci en matériau semiconducteur fortement dopé est déposé à la surface du substrat. Ce contact ohmique supporte l'ensemble des couches semiconductrices constitutives de la structure à multi-puits quantiques MPQ.

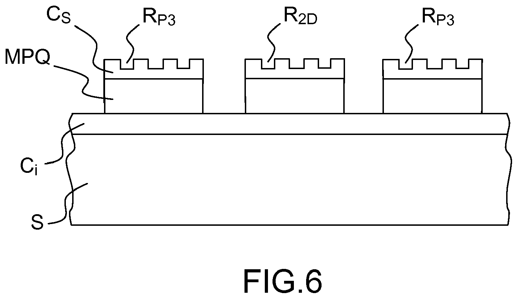

Celle-ci est en contact avec un assemblage de couches constituant un contact ohmique dit supérieur Cs, la détection étant assurée entre les deux contacts ohmiques. Avantageusement les réseaux diffractifs constitués de motifs lamellaires peuvent être gravés dans la couche de contact ohmique comme illustré en figure 6 qui représente une vue en coupe selon l'axe AA' représenté en figure 5.

### Exemple de réalisation d'un imageur selon l'invention :

Nous allons décrire un exemple d'imageur selon l'invention, fonctionnant dans le domaine infrarouge et plus particulièrement adapté aux domaines 8-12 microns :
Sur un substrat en GaAs intrinsèquement non dopé, on réalise le dépôt de la couche de contact ohmique inférieur en GaAs dopé Si avec un taux de dopage de 1.10¹⁸ cm⁻³ et une épaisseur typiquement de 2 microns.

La structure à multi-puits quantiques est réalisée par l'empilement de 50 puits composés d'une couche de GaAs dopée silicium avec une concentration en porteurs de charge de 2 10¹¹ cm⁻² d'épaisseur 5 nm, insérée entre deux couches barrières constituées de Ga_{0,75}Al_{0,25}As d'épaisseur 50 nm.

La couche de contact supérieur est semblable à la couche de contact inférieur.

Les motifs lamellaires sont réalisés au sein de cette couche de contact supérieur.

Pour obtenir les effets diffractants recherchés à une longueur d'onde de fonctionnement de 9 microns, les profondeurs de gravure sont de 0.7 micron et le pas des motifs est de 2,7 microns (l'indice moyen de la structure étant de 3,3 microns à 9 microns).

Le taux de remplissage de la surface de la couche de contact supérieur est typiquement de l'ordre de 50%. Les différents réseaux de diffraction R_{P1}, R_{P2}, R_{P3} sont réalisés en orientant selon une direction privilégiée les différents motifs lamellaires.

## Revendications

1. Dispositif d'imagerie polarimétrique comprenant une structure à multipuits quantiques qui comprend une matrice de pixels élémentaires de détection fonctionnant sur des transitions intersousbande par absorption d'un rayonnement à une longueur d'onde lambda, ladite matrice de pixels élémentaires de détection étant destinée à être éclairée par ledit rayonnement, chaque pixel élémentaire de détection comprenant un plot distinct (C_{S}, MPQ) formé d'un empilement de couches semiconductrices (MPQ) réalisé à la surface d'un substrat (S) et constitutif de la structure à multi-puits quantiques, la matrice étant organisée en sous-ensemble de quatre pixels élémentaires, chacun desdits sous-ensemble comprenant :
- un premier pixel polarimétrique comportant un premier réseau diffractif (R_{P1}) sensible à une première polarisation et disposé à la surface du plot du premier pixel,
- un second pixel polarimétrique comportant un second réseau diffractif (R_{P2}) sensible à une deuxième polarisation orthogonale à la première polarisation et disposé à la surface du plot du second pixel,
- un troisième pixel polarimétrique comportant un troisième réseau diffractif (R_{P3}) sensible à une troisième polarisation orienté selon une angle compris entre les première et seconde polarisations et disposé à la surface du plot du troisième pixel, et **caractérisé en ce que** chacun desdits sous-ensembles comprend:
- un quatrième pixel ne comportant pas de réseau diffractif sélectif en polarisation,
et **en ce que** le dispositif comporte en outre des moyens de traitement des signaux récupérés au niveau des pixels de détection, les moyens de traitement des signaux comprenant des moyens de sommation des signaux issus respectivement des premier, second, troisième pixels de détection et des moyens de soustraction du signal issu du quatrième pixel de détection.

2. Dispositif d'imagerie polarimétrique selon la revendication 1, ***caractérisé* en ce que** le quatrième pixel ne comporte pas de réseau diffractif

3. Dispositif d'imagerie polarimétrique selon la revendication 1, ***caractérisé* en ce que** le quatrième pixel comporte un quatrième réseau diffractif (R_{2D}) non sélectif en polarisation.

4. Dispositif d'imagerie polarimétrique selon l'une des revendications 1 à 3, ***caractérisé* en ce que** le troisième pixel comporte un réseau diffractif sensible à une troisième polarisation orientée selon un angle de 45° par rapport aux première et deuxième polarisations.

5. Dispositif d'imagerie polarimétrique selon l'une des revendications 1 à 4, ***caractérisé* en ce que** les premier, second et troisième réseaux de diffractions sont des réseaux à une dimension comportant des motifs lamellaires.

6. Dispositif d'imagerie polarimétrique selon la revendication 5, ***caractérisé*** en ce ledit empilement de couches comprend un contact ohmique (C_{S}) disposé sur chacun des plots de la matrice de plots, les motifs lamellaires étant gravés au sein dudit contact ohmique (C_{S}) de manière à réaliser les différents réseaux.

7. Dispositif d'imagerie polarimétrique selon la revendication 6, ***caractérisé* en ce que** l'empilement des couches est un empilement de couches semiconductrices de type GaAs ou InGaAs dopé (constituant les puits) et AlGaAs ou InAlAs non dopé (constituant les barrières), le substrat étant de type GaAs ou InP non dopé.

8. Dispositif d'imagerie polarimétrique selon la revendication 7, ***caractérisé* en ce que** ledit empilement de couches semiconductrices est composée d'une alternance de couches de GaAs dopé et de couches de GaAlAs non dopé et comprend des couches de contact ohmique à base de GaAs plus fortement dopé que les couches de l'empilement constitutives de la structure à multipuits quantiques.

9. Dispositif d'imagerie polarimétrique selon l'une des revendications 6 à 8, ***caractérisé* en ce qu'**il comprend un substrat transparent à la longueur d'onde du rayonnement incident et une couche réflectrice à ladite longueur d'onde, ladite couche réflectrice étant à la surface des réseaux de diffraction, de manière à faire fonctionner le détecteur en réflexion.

10. Dispositif d'imagerie multispectrale selon l'une quelconque des revendications 2 - 8, ***caractérisé* en ce que** la matrice de pixels élémentaires de détection comprend :
- le substrat (S) en matériau semi-conducteur ;
- une couche (Cᵢ) formant un premier contact ohmique en matériau semi-conducteur fortement dopé, déposée sur le substrat ;
- la matrice de plots disposées sur ledit contact ohmique ; et
- un second contact ohmique (C_{S}) disposé sur chacun des plots de la matrice de plots.

## Patentansprüche

1. Vorrichtung zur polarimetrischen Bildgebung, umfassend eine Struktur aus vielzähligen Quantentöpfen, die eine an Intersubbandübergängen durch Absorption einer Strahlung bei Lambda-Wellenlänge arbeitenden Matrix von elementaren Detektionspixeln umfasst, wobei die besagte Matrix von elementaren Detektionspixeln dazu bestimmt ist, durch die Strahlung beleuchtet zu werden, wobei jedes elementare Detektionspixel ein unterschiedliches Plot (C_{S}, MPQ) umfasst, das aus einem Stapel von Halbleiterschichten (MPQ) besteht, die auf der Oberfläche eines Substrats (S) gebildet sind und die multiple Quantentopfstruktur bilden, wobei die Matrix in Unter-Einheiten von je vier elementaren Pixeln organisiert ist und wobei jede der besagten Untereinheiten folgendes umfasst:
- ein erstes polarimetrisches Pixel, umfassend ein erstes diffraktives Gitter (R_{P1}), das für eine erste Polarisation empfindlich ist und auf der Oberfläche des Plots des ersten Pixels angeordnet ist,
- ein zweites polarimetrisches Pixel, umfassend ein zweites diffraktives Gitter (R_{P2}), das für eine zweite Polarisation orthogonal zur ersten Polarisation empfindlich ist und auf der Oberfläche des Plots des zweiten Pixels angeordnet ist,
- ein drittes polarimetrisches Pixel mit einem dritten diffraktiven Gitter (R_{P3}), das für eine dritte Polarisation empfindlich ist, die in einem Winkel zwischen der ersten und der zweiten Polarisation ausgerichtet ist und auf der Oberfläche des Plots des dritten Pixels angeordnet ist,
**dadurch gekennzeichnet, dass** jede der besagten Unter-Einheiten folgendes umfasst:
- ein viertes Pixel ohne ein selektives polarisationsbeugendes Gitter,
sowie dadurch, dass die Vorrichtung ferner Mittel zur Verarbeitung der an den Erfassungspixeln gewonnenen Signale umfasst, wobei die Signalverarbeitungsmittel Mittel zum Summieren der Signale aus den ersten, zweiten, dritten Erfassungspixeln und Mittel zum Subtrahieren des Signals aus dem vierten Erfassungspixel umfassen.

2. Vorrichtung zur polarimetrischen Bildgebung gemäß Anspruch 1, **dadurch gekennzeichnet, dass** das vierte Pixel kein Beugungsgitter aufweist.

3. Vorrichtung zur polarimetrischen Bildgebung gemäß Anspruch 1, **dadurch gekennzeichnet, dass** das vierte Pixel ein viertes Beugungsgitter (R_{2D}) aufweist, das in der Polarisation unselektiv ist.

4. Vorrichtung zur polarimetrischen Bildgebung gemäß einem der Ansprüche 1 bis 3, **dadurch gekennzeichnet, dass** das dritte Pixel ein Beugungsgitter umfasst, das für eine dritte Polarisation empfindlich ist, die in einem Winkel von 45° zur ersten und zweiten Polarisation ausgerichtet ist.

5. Vorrichtung zur polarimetrischen Bildgebung gemäß einem der Ansprüche 1 bis 4, **dadurch gekennzeichnet, dass** die ersten, zweiten und dritten Beugungsgitter eindimensionale Gitter mit lamellaren Mustern sind.

6. Vorrichtung zur polarimetrischen Bildgebung gemäß Anspruch 5, **dadurch gekennzeichnet, dass** der Schichtstapel einen ohmschen Kontakt (C_{S}) umfasst, der auf jedem der Plots des Plotgitters angeordnet ist, wobei die lamellaren Muster innerhalb des ohmschen Kontakts (C_{S}) eingraviert sind, um die verschiedenen Gitter zu realisieren.

7. Vorrichtung zur polarimetrischen Bildgebung gemäß Anspruch 6, **dadurch gekennzeichnet, dass** die Schichtstapelung eine Stapelung von HalbleiterSchichten vom Typ dotierte GaAs- oder InGaAs (die die Töpfe bilden) und vom Typ undotierte AlGaAs oder InAlAs (die die Schranken bzw. Barrieren bilden) ist, wobei das Substrat vom undotierten GaAs- oder InP-Typ ist.

8. Vorrichtung zur polarimetrischen Bildgebung gemäß Anspruch 7, **dadurch gekennzeichnet, dass** der Halbleiterschichtaufbau aus einem Wechsel von dotierten GaAs-Schichten und undotierten GaAlAs-Schichten besteht und höher dotierte ohmsche GaAs-Kontaktschichten umfasst als die Stapellagen, die die Quanten-Multitopfstruktur bilden.

9. Vorrichtung zur polarimetrischen Bildgebung gemäß einem der Ansprüche 6 bis 8, **dadurch gekennzeichnet, dass** sie ein Substrat, das für die Wellenlänge der einfallenden Strahlung transparent ist, und eine Reflexionsschicht dieser Wellenlänge umfasst, wobei sich die besagte Reflexionsschicht auf der Oberfläche der Beugungsgitter befindet, um den Detektor in Reflexion zu betreiben.

10. Multispektrale Bildgebungsvorrichtung gemäß einem der Ansprüche 2 - 8, **dadurch gekennzeichnet, dass** die Anordnung der elementaren Detektionspixel folgendes umfasst:
- das Substrat (S) aus Halbleitermaterial;
- eine Schicht (Cᵢ), die einen ersten, auf dem Substrat aufgetragenen ohmschen Kontakt aus hochdotiertem Halbleitermaterial bildet;
- das Plotgitter, welches auf dem besagten ohmschen Kontakt angeordnet ist; und
- einen zweiten ohmschen Kontakt (C_{S}), der auf jedem der Plots des Plotgitters angeordnet ist.

## Claims

1. Polarimetric imaging device comprising a multiple-quantum-well structure comprising a matrix of individual detection pixels operating on inter-sub-band transitions by absorbing radiation at a wavelength λ, said matrix of individual detection pixels being intended to receive said radiation, each individual detection pixel comprising a distinct stud (Cᵤ, MQW) made of a stack of semiconductor layers (MQW) realised on top of a substrate (S) and constituting the multiple-quantum-well structure, said matrix being organized in subsets of four individual pixels, each subset comprising :
• a first polarimetric pixel comprising a first diffraction grating (R_{P1}) sensitive to a first polarization and disposed on the surface of the stud of the firt pixel ;
• a second polarimetric pixel comprising a second diffraction grating (R_{P2}) sensitive to a second polarization orthogonal to the first polarization and disposed on the surface of the stud of the second pixel ;
• a third polarimetric pixel comprising a third diffraction grating (R_{P3}) sensitive to a third polarization oriented at an angle between the first and second polarizations and and disposed on the surface of the stud of the third pixel ;
**characterized in that** each of said subset comprises a fourth pixel not comprising a polarization-selective diffraction grating, and **in that** the device further includes means for processing the signals recovered from the detection pixels, said signal processing means comprising means for summing the signals coming from the first, second and third detection pixels respectively and means for subtracting the signal coming from the fourth detection pixel.

2. Polarimetric imaging device according to Claim 1, wherein the fourth pixel does not comprise a diffraction grating.

3. Polarimetric imaging device according to Claim 1, wherein the fourth pixel comprises a non-polarization-selective fourth diffraction grating (R_{2D}).

4. Polarimetric imaging device according to one of Claims 1 to 3, wherein the third pixel comprises a diffraction grating sensitive to a third polarization oriented at an angle of about 45° to the first and second polarization.

5. Polarimetric imaging device according to one of Claims 1 to 4, wherein the first, second and third diffraction gratings are one-dimensional gratings having lamellar patterns.

6. Polarimetric imaging device according to Claim 5, wherein said stack of layers comprises a ohmic contact (Cᵤ) disposed on each of the suds of the matrix of studs, the lamellar patterns being etched in said ohmic contact (Cᵤ) in order to realize the different gratings.

7. Polarimetric imaging device according to Claim 6, wherein the multilayer stack is a stack of semiconductor layers of the doped GaAs or InGaAs type (constituting the wells) and layers of the undoped AIGaAs or InAIAs type (constituting the barriers), the substrate being of the undoped GaAs or InP type.

8. Polarimetric imaging device according to Claim 7, wherein said stack of semiconductor layers is composed of an alternation of doped GaAs layers and undoped GaAIAs layers and comprises GaAs-based ohmic contact layers that are more highly doped than the layers of the stack making up the multiple-quantum-well structure.

9. Polarimetric imaging device according to one of Claims 6 to 8, comprising a substrate which is transparent at the wavelength of the incident radiation and a layer which is reflective at said wavelength, said reflective layer being on the surface of the diffraction gratings, so as to make the detector operate in reflection.

10. Multispectral imaging device according to one of Claims 2 to 8, wherein the matrix of individual detection pixels comprises :
• the substrate (S) made of semiconductor material;
• a layer forming a first ohmic contact (Cₗ) made of a highly doped semiconductor deposited on the substrate ;
• the matrix of studs deposited on said ohmic contact;
• a second ohmic contact (Cᵤ) deposited on each of the studs of the matrix of studs.
